# EUROPEAN PATENT APPLICATION

(11) **EP 1 707 299 A1**
(43) Date of publication of application: **04.10.2006**
(21) Application number: 05704160.0
(22) Date of filing: 20.01.2005
(51) Int. Cl.: B23K 26/38

(54) **STRETCHED POLYTETRAFLUOROETHYLENE POROUS ARTICLE HAVING FINE PORES FORMED THEREIN AND METHOD FOR PRODUCTION THEREOF, AND METHOD OF ABLATION MACHINING**

(30) Priority: 23.01.2004 JP 2004016286
(71) Applicant: Sumitomo Electric Industries, Ltd., Osaka-shi, Osaka 541-0041 (JP)
(72) Inventor: KOSUDA, Yasuhito, Sumitomo Electric Industries,Ltd, Osaka-shi, Osaka 5540024 (JP); OKUDA, Yasuhiro, Sumitomo Electric Industries,Ltd, Osaka-shi, Osaka 5540024 (JP); MISHIMA, Hidehiko, Sumitomo Electric Ind.,Ltd., Osaka-shi, Osaka 5540024 (JP)
(74) Representative: Cross, Rupert Edward Blount
(86) International application number: PCT/JP2005/001051
(87) International publication number: WO 2005/070611

(57) **Abstract**

A microhole-formed stretched porous polytetrafluoroethylene material, in which a microhole having a hole diameter greater than an average pore diameter of a stretched porous polytetrafluoroethylene material is formed in the stretched porous polytetrafluoroethylene material by irradiation of a pulse laser beam having a pulse length of at most 10 picoseconds, and the microporous structure of the wall surface of the microhole is substantially retained without being destroyed, a production process thereof, and an abrasion working process.

## Description

### TECHNICAL FIELD

The present invention relates to a stretched porous polytetrafluoroethylene material (hereinafter abbreviated as "stretched porous PTFE material"), in which a microhole is formed, and a production process thereof, and particularly to a microhole-formed stretched porous PTFE material in which a microporous structure of a wall surface in the microhole is substantially retained without being destroyed, and a production process thereof. The present invention also relates to a process for abrading a material to be wrought by irradiation of a pulse laser beam.

The microhole-formed stretched porous PTFE material according to the present invention can be suitably applied to, for example, technical fields of mounting members of semiconductor devices, members for inspection of electrical reliability, and the like by selectively applying a conductive material such as plated particles to the wall surface of the microhole. Besides, the microhole-formed stretched porous PTFE material can be widely applied to technical fields, of which formation of a microhole precisely designed is required, without impairing properties inherent in the stretched porous PTFE material.

### BACKGROUND ART

A stretched porous PTFE material has a microporous structure comprising fibrils (fine fibers) and nodes connected to each other by the fibrils and having a feature that a porous material excellent in heat resistance, chemical resistance, workability, mechanical properties, dielectric characteristics (low dielectric constant) and the like and having an even hole diameter distribution is easy to be provided among various kinds of porous synthetic resin materials. Stretched porous PTFE materials such as a stretched porous PTFE film have electrically insulating property and moderate elasticity and can be elastically recovered even when it is compressed.

If microworking including formation of a microhole can be conducted on a stretched porous PTFE material, it can be applied to, for example, technical fields of mounting members of semiconductor devices, members for inspection of electrical reliability, and the like making good use of such excellent properties as described above. More specifically, if patterned micro through-holes can be formed in the stretched porous PTFE film, conductive portions can be formed by selectively applying a conductive metal to wall surfaces of the through-holes.

It is often necessary to form a through-hole, through-groove and/or recessed portion (for example, non-through-hole or non-through-groove) in a substrate for fabrication of an electronic part. It can be permitted to achieve electrical connection or form an electric circuit by filling the through-hole, through-groove and/or recessed portion with a conductive material or forming a plated layer on the surface of the through-hole, through-groove and/or recessed portion.

For example, in a double-sided printed wiring board or multi-layer printed wiring board, wiring patterns formed on both surfaces or respective layers are connected by a silver through-hole with a through-hole formed in the board filled with silver or a plated through-hole with the through-hole subjected to plating. As a semiconductor package, is known an insertion type package that a lead introduced from a package is inserted into a substrate, in which a hole called a through-hole has been made, to fabricate a package. If microholes having a desired pattern can be precisely formed in a stretched porous PTFE film, it may be applied as a new substrate material having elasticity and elastic recovery property.

Since the stretched porous PTFE material has a porous structure composed of a micro-fibrous structure comprising extremely fine fibrils and nodes, however, it is difficult to form a microhole. The application of a conventional hole-forming process to the stretched porous PTFE material involves a problem that the microporous structure of the stretched porous PTFE material is easy to be destroyed, in addition to the difficulty of forming a precise and fine hole.

There has heretofore been proposed a process for conducting microworking by irradiating a formed PTFE material with an ultraviolet laser beam [for example, S. Wada et al. Appl. Phys. Lett. 63, 211 (1993)]. It is however extremely difficult to apply this process to the perforation of the stretched porous PTFE material. When the stretched porous PTFE material is irradiated with an ultraviolet laser beam, not only a microhole is formed by chemical and physical breaking, decomposition, cutting and evaporation, but also the fibrils are fused by heat generated by the irradiation of the laser beam to collapse a peripheral microporous structure including a wall surface of the microhole, so that the properties inherent in the stretched porous PTFE material are impaired.

As perforating methods for forming a through-hole in a printed wiring board, are known, for example, machine-working methods such as punching by a punch die and cutting by a drill. When such machine-working methods are applied to the microworking of the stretched porous PTFE material, however, it is difficult to form a precise microhole, and a peripheral microporous structure including a wall surface of the microhole is destroyed by shearing force and frictional heat upon the working.

On the other hand, in recent years, there has been proposed a laser induced breakdown method for materials making use of a pulse laser beam having a small pulse length (for example, Japanese Patent No. 3283265). However, this laser induced breakdown method making use of the pulse laser beam is only applied to the provision of a cut hole in an opaque material such as gold or a transparent material such as glass, or the damaging of a vital tissue such as a cornea.

As a process for patterning a thin film such as an ITO film formed on a transparent substrate such as a glass substrate or polyethylene terephthalate (PET) film in a prescribed form, has heretofore been proposed a thin film-abrading process in which a laser beam having an ultrashort pulse and a wavelength selectively absorbed in the thin film for abrading the thin film is caused to be incident from the side of the transparent substrate, and the laser beam transmitted through the transparent substrate is irradiated onto the thin film to abrade the irradiated portions (Japanese Patent Application Laid-Open No. 2002-160079).

When the surface of the thin film is irradiated with the laser beam to abrade the film, fine particles (debris) flown off by the abrasion proceed to a reverse direction to the proceeding direction of the incident laser beam, so that the fine particles strike on the laser beam to cause scattering of the laser beam, thereby lowering working precision. On the other hand, according to the above-described abrading process, in which the laser beam is irradiated from the side of the transparent substrate, the scattering of the laser beam by the fine particles flown off from the thin film can be prevented to create a highly precisely wrought state with a beautiful patterned form.

However, according to the abrading process, in which the laser beam is irradiated from the side of the substrate (support), fine particles generated by the abrasion of the substrate scatter the laser beam to change the form of the laser beam. Therefore, the above-described abrading process requires using, as the substrate, a substrate formed from a material having light absorption characteristics that a band gap inherent in the material is greater than a band gap of the thin film that is a material to be wrought. In order to abrade the material to be wrought without abrading the substrate, the kind of the pulse laser beam that is transmitted through the substrate, but absorbed in the material to be wrought must be selected. Such selection of the material of the substrate (support) and selection of the laser beam requires labor and cost.

There has heretofore been proposed a process for treating a material using a laser pulse beam, which comprises a step of generating a laser pulse beam (i.e., pulse laser beam), a step of focusing the beam on a focal plane above the surface of a sample, a step of causing breakdown of a material of the sample at a laser irradiation point, and a step of removing or modifying the sample material by the beam (Japanese Patent Application Laid-Open No. 2002-316278). In this document, metals, alloys, ceramics, glass, sapphire, diamond, organic materials (for example, polyimide and PMMA) and silicon are mentioned as examples of the sample material.

According to the above-described treatment process, the focal point of the laser pulse beam is shifted by 2 to 10 µm above from the surface of the sample, thereby permitting the use of a laser beam pulse of a higher intensity, so that the adverse influence of the sample surface condition on absorption of laser energy can be minimized. The material removed from the sample by the irradiation of the beam can be removed by a push-pull type vacuum system arranged somewhat above the surface of the sample, thereby preventing reprecipitation on the sample surface of the material abraded.

However, the above-described treatment process requires arranging the vacuum system equipped with an air supply manifold generating an air jet and a vacuum manifold for preventing the reprecipitation on the sample surface of the material abraded. In order to apply the treatment process to the perforation of a sample, it is actually necessary to support the sample on a support. However, the support is abraded by using the laser beam pulse of the higher intensity, and so the sample and a perforation form are adversely affected by fine particles flown off. More specifically, the matter flown off by the abrasion of the support strikes on the laser pulse beam to incur scattering of the beam. This phenomenon is called a plasma phenomenon. Due to this plasma phenomenon, the influence on the beam extends to a peripheral portion adjoining the focused laser irradiation point, and heat is generated, so that the sample and perforation form are adversely affected.

In order to inhibit the adverse influence by the abrasion of the support, it is considered to lower the fluence of the pulse laser beam. However, the energy of this beam is thereby lowered to slow an acceleration speed. When the focal position of the pulse laser beam is shifted from the surface of the sample, the plasma phenomenon can be kept away from the sample. However, energy loss becomes great because the focal point is shifted.

### DISCLOSURE OF THE INVENTION

It is an object of the present invention to provide a stretched porous polytetrafluoroethylene material, in which a microhole is formed, and a microporous structure of a wall surface in the microhole is substantially retained without being destroyed.

Another object of the present invention is to provide a novel process for precisely working a stretched porous polytetrafluoroethylene material to form a microhole having desired form and size therein substantially without destroying the microporous structure thereof.

A further object of the present invention is to provide a novel process for abrading a material to be wrought such as a stretched porous polytetrafluoroethylene material by irradiating the material to be wrought with a pulse laser beam in a state supported on a support to abrade non-irradiated portions, by which the condition of the wrought surface is not adversely affected by abrasion of the support.

The present inventors have carried out an extensive investigation with a view toward achieving the above objects. As a result, it has been found that a stretched porous PTFE material having a microporous structure comprising fibrils and nodes connected to each other by the fibrils is irradiated with a pulse laser beam having a pulse length of 10 picoseconds or shorter, whereby a microhole having a hole diameter greater than an average pore diameter of the stretched porous PTFE material can be precisely formed without destroying the microporous structure due to fusion of the fibrils by heat generated by the irradiation, or the like.

In the microhole-formed stretched porous PTFE material according to the present invention, the microporous structure of a wall surface in each microhole is substantially retained without being destroyed, so that the elasticity and elastic recovery property of the material are not impaired. When plated particles are selectively applied to the wall surface of the microhole, the plated particles are firmly applied to the microporous structure of the wall surface. When the amount of the plated particles applied is controlled, the elasticity and elastic recovery property of the stretched porous PTFE material can be substantially retained.

In some cases, it is preferable to support a material to be wrought such as a stretched porous PTFE material on a support to irradiate the material with a pulse laser beam. In such a case, the condition of the wrought surface of the material to be wrought is often adversely affected by particles flown off by abrasion of the support. For example, it has been proved that when the stretched porous PTFE material is supported on the support to form a through-hole in the material by irradiation of a laser beam, the form of the through-hole on the side coming into contact with the support is adversely affected by the particles flown off by abrasion of the support.

The present inventors have conceived an abrasion working process using, as the support, a support provided with a site (for example, a bore) coming into no contact with the material to be wrought at a region corresponding to a target working region of the material to be wrought. According to this abrasion working process, particles flown off by abrasion of the support do not worsen the condition of the wrought surface even when the surface of the material to be wrought is irradiated with the laser beam.

The present invention has been led to completion on the basis of these findings.

According to the present invention, there is thus provided a microhole-formed stretched porous polytetrafluoroethylene material, characterized in that a microhole having a hole diameter greater than an average pore diameter of a stretched porous polytetrafluoroethylene material having a microporous structure comprising fibrils and nodes connected to each other by the fibrils is formed in the stretched porous polytetrafluoroethylene material by irradiation of a pulse laser beam having a pulse length of 10 picoseconds or shorter, and the microporous structure of the wall surface of the microhole is substantially retained without being destroyed.

According to the present invention, there is also provided a process for producing a microhole-formed stretched porous polytetrafluoroethylene material, which comprises irradiating a stretched porous polytetrafluoroethylene material having a microporous structure comprising fibrils and nodes connected to each other by the fibrils with a pulse laser beam having a pulse length of 10 picoseconds or shorter to form a microhole having a hole diameter greater than an average pore diameter of the stretched porous polytetrafluoroethylene material, wherein the microporous structure of the wall surface of the microhole is substantially retained without being destroyed.

According to the present invention, there is further provided a process for abrading a material to be wrought by irradiation of a pulse laser beam, which comprises irradiating the material to be wrought with the pulse laser beam in a state that the material to be wrought has been supported on a support, and at this time, using, as the support, a support provided with a site coming into no contact with the material to be wrought at a region corresponding to a working region of the material to be wrought.

### BRIEF DESCRIPTION OF THE DRAWINGS

Fig. 1 is a microphotograph of a section of a stretched porous PTFE film in which a through-hole is formed.
Fig. 2 is an enlarged microphotograph of a wall surface of the through-hole in Fig. 1.
Fig. 3 is an explanatory view (cross-sectional view) illustrating how to conduct abrasion by supporting a material to be wrought on a support provided with a bore.
Fig. 4 is an explanatory view (cross-sectional view) illustrating how to conduct abrasion by supporting a material to be wrought on a support having no bore.
Fig. 5 is a microphotograph of a section of a through-hole formed by supporting a stretched porous PTFE film on a support provided with a bore and conducting abrasion.
Fig. 6 is a microphotograph of a section of a through-hole formed by supporting a stretched porous PTFE film on a support having no bore and conducting abrasion.

### BEST MODE FOR CARRYING OUT THE INVENTION

The stretched porous PTFE material used in the present invention can be produced in accordance with, for example, the process described in Japanese Patent Publication No. 42-13560. A liquid lubricant is first mixed with unsintered powder of PTFE, and the resultant mixture is extruded into a tube or plate by ram extrusion. When a sheet having a small thickness is desired, the plate-like extruded product is rolled by pressure rolls. After the extrusion or rolling step, the liquid lubricant is removed from the extruded product or rolled product as needed. When the thus-obtained plate-like extruded product or rolled product is stretched in at least a uniaxial direction, an unsintered stretched porous PTFE material is obtained in the form of a film. When the unsintered stretched porous PTFE film is heated to a temperature of at least 327°C that is a melting point of PTFE while fixing it so as not to cause shrinkage, thereby fixing the stretched structure by sintering, a stretched porous PTFE film having high strength is obtained. When the stretched porous PTFE material is a tube, it can be formed into a flat film by cutting it in a longitudinal direction thereof. Although a material (referred to as "stretched porous PTFE film") in the form of a film is used as the stretched porous PTFE material in the present invention, that having any other form may also be used if desired.

The stretched porous PTFE material obtained by the stretching process has a micro-fibrous tissue comprising fibrils (very fine fibers) and nodes connected to each other by the fibrils, which are respectively formed by PTFE. In the stretched porous PTFE material, this micro-fibrous tissue forms a porous structure (referred to as "microporous structure").

In the stretched porous PTFE material, a resin portion of the microporous structure is composed of the fibrils and nodes, while a void portion of the microporous structure is composed of spaces (referred to as "porous spaces") formed by the fibrils and nodes. Although the stretched porous PTFE film may be used as the stretched porous PTFE material by itself, a plurality of the films may also be superimposed and pressure welded to one another to provide a multi-layer film or sheet integrally formed by fusion bonding.

The porosity of the stretched porous PTFE material is preferably at least 20%, more preferably at least 40%. It is desirable that the porosity of the stretched porous PTFE material falls within a range of preferably 20 to 90%, more preferably 40 to 80% for the purpose of reconciling low dielectric characteristics or strain-absorbing ability with shape-retaining ability.

The average pore diameter of the stretched porous PTFE material is preferably at most 10 µm, more preferably at most 5 µm, particularly preferably at most 1 µm. It is preferable that the average pore diameter of the stretched porous PTFE material be at most 1 µm, since such a material can be subjected to hyperfine working, and moreover a plated film can be firmly fixed to a wall surface of a microhole formed in the material by an anchoring effect. The average pore diameter of the stretched porous PTFE material may be made small to 0.1 µm or smaller.

The thickness of the stretched porous PTFE material may be suitably selected according to the purpose of use, a position used or the like. However, it is generally at most 3 mm, preferably at most 2 mm, and the lower limit thereof is of the order of generally 5 µm, preferably 10 µm. It is preferable that the thickness of the stretched porous PTFE material be controlled to generally 1 to 2 mm (1,000 to 2,000 µm) when a product obtained from the stretched porous PTFE material is used as a probe card for inspection of semiconductors, to generally at most 1 mm (1,000 µm), preferably at most 500 µm when used as a substrate material for flexible substrates or the like, or to at most 100 µm when used as a multi-layer high-density wiring board. As described above, the stretched porous PTFE material used in the present invention is preferably a stretched porous PTFE sheet or film (hereinafter referred to as "stretched porous PTFE film") having a thickness ranging from 5 µm to 3 mm.

In the present invention, a process of irradiating the stretched porous PTFE material with a pulse laser beam having a pulse length of 10 picoseconds or shorter is adopted for forming a microhole in the material.

The pulse length of the pulse laser beam irradiated is preferably from 10 femtoseconds (fs) to 10 picoseconds (ps). This pulse length is more preferably 20 to 1,000 fs, particularly preferably 30 to 500 fs. When the pulse length of the laser beam is short, it is possible to conduct precise microworking on the stretched porous PTFE material.

The energy of the pulse laser beam is preferably from 10 nanojoules (nJ) to 1 millijoule (mJ). This energy is more preferably from 1 microjoule (µJ) to 1 mJ, particularly preferably 10 to 800 µJ. In many cases, this energy is within a range of 50 to 600 µJ. When the energy falls within the above range, precise microworking may be conducted on the stretched porous PTFE material in cooperation with the pulse length.

The fluence (time integral value of a radiant flux passing through a unit area) of the pulse laser beam irradiated is generally at least 0.1 J/cm². The fluence of the pulse laser beam irradiated is preferably 0.1 to 20 J/cm², more preferably 0.3 to 10 J/cm².

The wavelength of the pulse laser beam preferably falls within a range of from 200 nm to 1 µm. This wavelength is more preferably within a range of from 300 to 900 nm. The frequency is within a range of preferably from 1 Hz to 10 kHz, more preferably from 1 Hz to 1 kHz, particularly preferably from 1 to 100 Hz. When the frequency is made high, the number of emissions (shots) of the pulse per unit time can be increased. As examples of a laser medium, may be mentioned titanium/sapphire (Ti/Saphire).

By adjusting the above various conditions, a microhole having desired opening shape and depth can be precisely wrought in the stretched porous PTFE film. In addition, in the microhole formed in accordance with the process of the present invention, the microporous structure of its wall surface is substantially retained without being destroyed. The microhole may be either a through-hole or a non-through-hole. The hole diameter of the microhole formed in the stretched porous PTFE material preferably falls within a range of from 0.1 µm to 1,000 µm. However, the hole diameter of the microhole is made greater than the average pore diameter of the stretched porous PTFE material. The sectional form of the microhole may be any of, for example, circular, star, octagonal, hexagonal, rectangular, triangular, ring and groove forms. With respect to the hole diameter of the microhole, a side or diameter according to its sectional form is made greater than the average pore diameter of the stretched porous PTFE material. Upon the irradiation of the pulse laser beam, a diaphragm or mask may be provided in an optical path to form a microhole having a desired sectional form. A beam spot size may also be changed to form a desired beam.

The hole diameter of the microhole may be controlled to preferably about 5 to 100 µm, more preferably about 5 to 30 µm in application fields for which a small hole diameter is fit. On the other hand, the hole diameter may be controlled to preferably about 100 to 1,000 µm, more preferably about 300 to 800 µm in application fields for which a relatively large hole diameter is fit. The microhole may be a single hole. However, a plurality of holes may be formed on a desired pattern as needed.

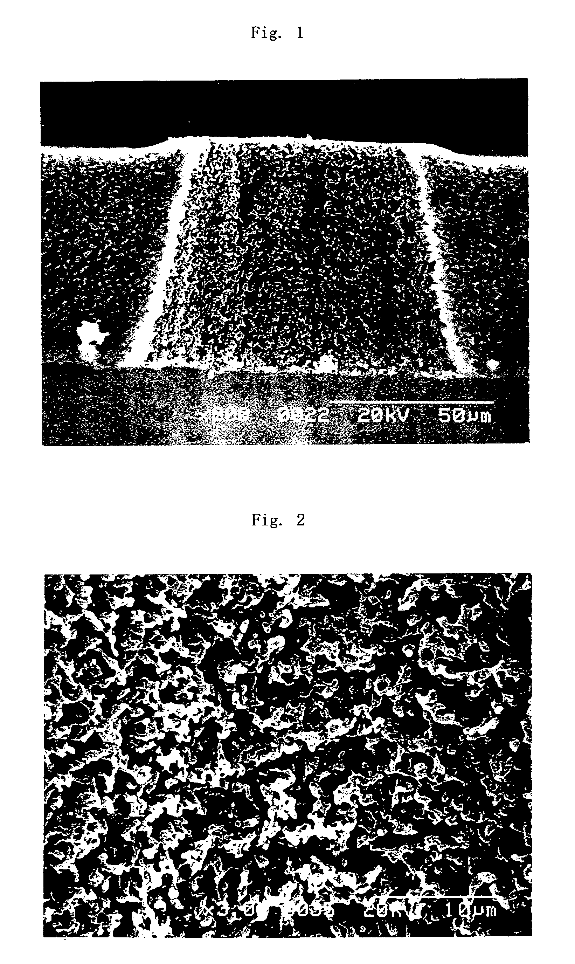

Fig. 1 shows a scanning electron microphotograph (SEM, about 800 magnifications) illustrating a section of a microhole (through-hole) formed in a stretched porous PTFE material in accordance with the process of the present invention. Fig. 2 is a scanning electron microphotograph (SEM, about 3,000 magnifications) illustrating a wall surface of the microhole on an enlarged scale. As apparent from these drawings, a microhole small in hemming bottom and excellent in sectional form can be formed by precise microworking according to the process of the present invention. It is also understood that the microporous structure of the wall surface of the microhole is substantially retained without being destroyed. The microporous structure around the microhole is also not destroyed by fusion.

Since the stretched porous PTFE material is generally a very soft stretched porous PTFE film, it may be preferable in some cases from the viewpoint of precision working that the film be supported on a support and wrought when it is abraded by irradiation of a pulse laser beam. However, it has been found that when the stretched porous PTFE material is supported on the support, and the pulse laser beam is irradiated from the side of the stretched porous PTFE material, a through-hole formed is greatly affected on its support side by particles flown off by abrasion of the support to greatly change its form.

The thin film-abrading process described in Japanese Patent Application Laid-Open No. 2002-160079 involves such problems that the kinds of the support (substrate) and the laser beam must be selected, the material to be wrought is limited to thin films such as an ITO film formed on the support, and it is difficult to sufficiently remove the adverse influence by the abrasion of the support, and so the process is not always suitable for a working process using an organic polymeric material such as a stretched porous PTFE material as a material to be wrought.

In the present invention, may be adopted an abrasion working process comprising irradiating a stretched porous PTFE material with a pulse laser beam in a state that the stretched porous PTFE material has been supported on a support, and at this time, using, as the support, a support provided with a site coming into no contact with the stretched porous PTFE material at a region corresponding to a target region of the stretched porous PTFE material, in which a microhole is formed.

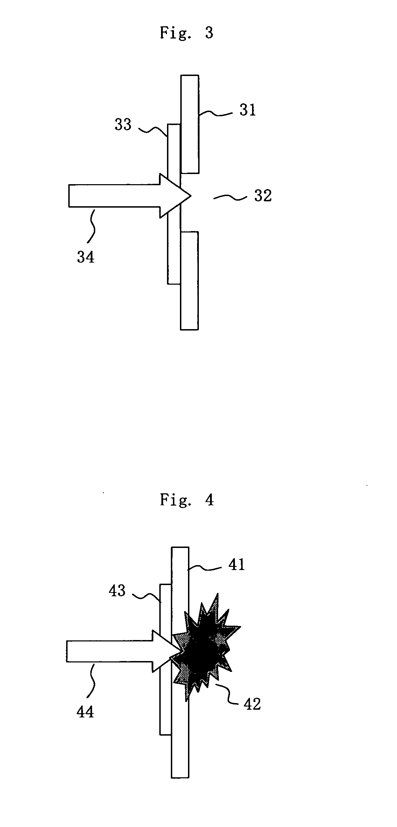

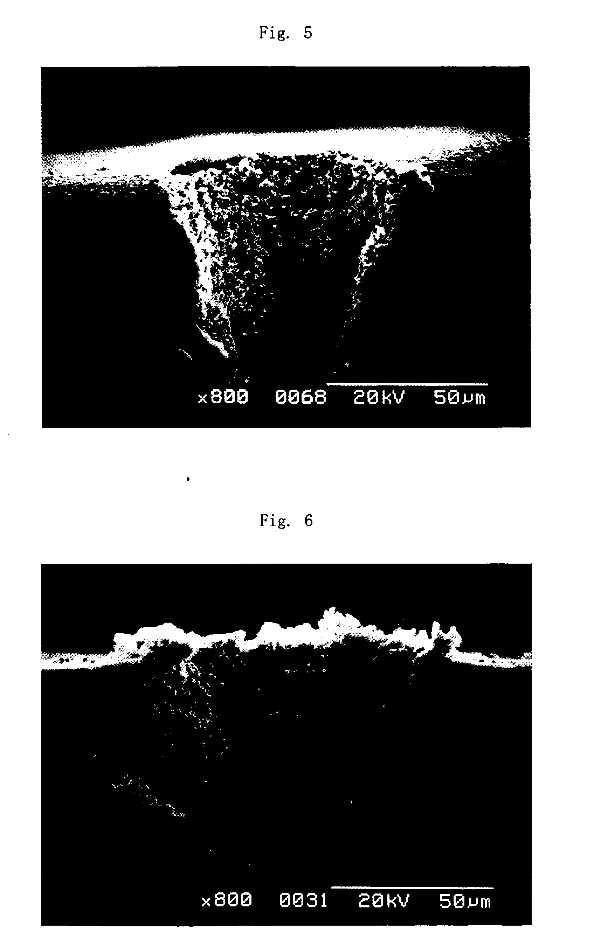

More specifically, as illustrated in Fig. 3, for example, a support (quartz substrate) 31 provided with a bore 32 is used as the support. This bore 32 is provided at a region corresponding a target region (working region) in which a microhole (through-hole) is formed in the stretched porous PTFE material (material 33 to be wrought). When this target region is irradiated with a pulse laser beam 34, many of particles flown off by abrasion of the stretched porous PTFE material (material 33 to be wrought) pass through the bore 32 and scatter off on a side opposite to the irradiation side. In addition, no particle flown off by abrasion of the support 31 is present, so that a microhole excellent in sectional form can be formed (Fig. 5). Further, the microporous structure of the wall surface of the microhole is substantially retained without being destroyed. The microporous structure around the microhole is also not destroyed by fusion.

On the other hand, when a stretched porous PTFE material (material 43 to be wrought) is supported on a support 41 having no bore, and the target region is irradiated with a pulse laser beam 44 as illustrated in Fig. 4, particles are flown off by abrasion 42 of the support 41, and the form of a through-hole formed is greatly collapsed, so that no microhole excellent in sectional form can be formed (Fig. 6).

More specifically, when the support provided with no bore at the region corresponding to the target working region of the material to be wrought is used to form a microhole in the stretched porous PTFE material by the irradiation of the pulse laser beam, as illustrated in Fig. 6 (SEM photograph), there are caused problems that (1) the form of an opening portion of the microhole becomes a form having acute irregularities with no beautiful contour line, (2) burr-like protuberance occurs at an opening edge of the microhole, (3) fissures, irregularities, cracks, fused portions of the resin (fibrils and nodes), and the like occur at the wall surface of the microhole (i.e., the porous structure is destroyed), and (4) the wall surface of the microhole becomes a non-linear irregular form.

On the other hand, when the support provided with the bore at the region corresponding to the target working region of the material to be wrought is used to form a microhole in the stretched porous PTFE material by the irradiation of the pulse laser beam, as illustrated in Fig. 5 (SEM photograph), there can be gained advantages that (1) an opening portion of the microhole substantially draws a beautiful contour line of a prescribed form (for example, a circle), and no acute irregularity occurs on the contour line, (2) no burr-like protuberance occurs at an opening edge of the microhole, (3) none of fissures, irregularities, cracks, fused portions of the resin (fibrils and nodes), and the like substantially occur at the wall surface of the microhole, and (4) the wall surface of the microhole substantially becomes a linear even smooth form.

More specifically, when the support provided with the bore at the region corresponding to the target working region of the material to be wrought is used to form the microhole in the stretched porous PTFE material by the irradiation of the pulse laser beam, the opening portion of the microhole draws an even contour line of the prescribed form. If burr-like protuberance is formed at the opening edge of the microhole, the height thereof is generally at most 30 µm, preferably at most 20 µm, more preferably at most 15 µm, so that a microhole substantially having no burr-like protuberance is formed. Supposing that a diameter (opening diameter on the irradiation side) of the opening portion formed by the irradiation of the pulse laser beam is A, and a diameter of an opening portion formed on the other side is B, the microhole satisfies the relationship of A ≥ B. In addition, if fissures, irregularities and/or cracks occur at the wall surface of the microhole, the depth thereof is generally at most 0.5 x A, preferably at most 0.4 x A, more preferably at most 0.3 x A. Accordingly, the wall surface of the microhole shows a smooth form.

No particular limitation is imposed on the material of the support. However, as examples thereof, may be mentioned quartz substrates, ceramic substrates, glass substrates, synthetic resin substrates and metal substrates. The site coming into no contact with the material to be wrought, which is provided in the support, is a bore (through-hole) as its representative example. However, it may also be a recess or groove.

The above working process is not limited to the case where the stretched porous PTFE material is used as the material to be wrought, but may be applied to an abrading method for a wide variety of materials to be wrought. In other words, the abrasion working process according to the present invention is a process for abrading a material to be wrought by irradiation of a pulse laser beam, which comprises irradiating the material to be wrought with the pulse laser beam in a state that the material to be wrought has been supported on a support, and at this time, using, as the support, a support provided with a site coming into no contact with the material to be wrought at a region corresponding to a target working region of the material to be wrought.

No particular limitation is imposed on the material to be wrought. However, it is preferably an organic polymeric material. Examples of the organic polymeric material include polyolefin resins, polyamide resins, polyester resins, liquid crystal polymers, methacrylic resins, polystyrene resins, polyvinyl chloride resins, polycarbonate resins, polysulfone resins, poly(phenylene sulfide) resins, cycloolefin resins, polyimide resins, epoxy resins, phenol resins and fluorocarbon resins.

Examples of the fluorocarbon resins include polytetrafluoroethylene (PTFE), tetrafluoroethylene/hexafluoropropylene copolymers (FEPs), tetrafluoroethylene/perfluoroalkyl vinyl ether copolymers (PFAs), polyvinylidene fluoride (PVDF), polyvinylidene fluoride copolymers and ethylene/tetrafluoroethylene copolymers (ETFEs).

The organic polymeric material may also be an organic polymeric porous material. Examples of the organic polymeric porous material include porous materials of the above-mentioned fluorocarbon resins. As the organic polymeric porous material, is preferred a stretched porous PTFE material.

The conditions for the irradiation of the pulse laser beam vary according to the kind and shape of the material to be wrought. However, the pulse length of the pulse laser beam irradiated is generally 400 picoseconds (ps) or shorter, preferably 100 picoseconds or shorter, more preferably 10 picoseconds or shorter. This pulse length is generally 10 femtoseconds (fs) or longer, preferably 20 femtoseconds or longer, more preferably 30 femtoseconds or longer.

The energy of the pulse laser beam irradiated is generally from 10 nanojoules (nJ) to 1 millijoule (mJ), preferably from 1 microjoule (µJ) to 1 millijoule (mJ), more preferably from 10 to 800 microjoules, particularly preferably from 50 to 600 microjoules. The fluence of the pulse laser beam irradiated is generally at least 0.1 J/cm², preferably at least 0.3 J/cm². This fluence is generally at most 20 J/cm², more preferably at most 10 J/cm². The fluence of the pulse laser beam is preferably from 0.3 to 10 J/cm².

The material to be wrought may be abraded in any form of through-holes, grooves, recesses, various patterns, etc. Accordingly, a region coming into no contact with the material to be wrought, such as a bore, is formed in the support according to the target working region of the material to be wrought.

### EXAMPLES

The present invention will hereinafter be described more specifically by the following Examples and Comparative Examples. However, the present invention is not limited to these examples only. Physical properties were measured in accordance with the following respective methods.

### (1) Porosity:

A porosity of a stretched porous PTFE material was measured in accordance with ASTM D-792.

### Example 1

A stretched porous PTFE film (porosity: 60%, average pore diameter: 0.1 µm) having a thickness of 60 µm was irradiated by 20 shots with a Ti/Sapphire laser beam under conditions of a wavelength of 800 nm, a pulse length of 130 fs, energy of 200 µJ and a frequency of 10 Hz to form a through-hole. As illustrated in Fig. 1, the sectional form of the through-hole is small in hemming bottom and good. The average diameter is about 80 µm. As illustrated in Fig. 2, the microporous structure (fibrils and nodes) of the wall surface of the through-hole was substantially retained without being destroyed.

### Comparative Example 1

The same stretched porous PTFE film as that used in Example 1 was irradiated by 45 shots with an ArF laser beam having a wavelength of 192 nm, a pulse length of 9 ns, energy of 50 mJ and a frequency of 5 Hz to form a through-hole (average hole diameter: 280 µm). In the wall surface of the through-hole, it was confirmed that PTFE fibrils were fused, and the microporous structure was impaired to become non-porous.

### Example 2

A stretched porous PTFE film (porosity: 60%, average pore diameter: 0.1 µm) having a thickness of 60 µm was irradiated by 50 shots with a Ti/Sapphire laser beam under conditions of a wavelength of 800 nm, a pulse length of 170 fs, energy of 200 µJ and a frequency of 10 Hz in a state that the stretched porous PTFE film had been placed and supported on a quartz substrate to form a through-hole. In the quartz substrate, a bore larger than the through-hole had been formed at its region corresponding to the target region of the stretched porous PTFE film, in which the through-hole was formed, in advance before use.

As illustrated in Fig. 5 (SEM photograph), an opening portion of the through-hole draws an even contour line of a prescribed form (circle), and no burr-like protuberance having a height of 15 µm or greater is present at an opening edge of the through-hole. The sectional form of the through-hole is small in hemming bottom and good. The wall surface of the through-hole has none of irregularities, cracks, fused portions of the resin and the like and shows a smooth state. More specifically, supposing that an opening diameter (an upper opening diameter in Fig. 5) formed by the irradiation of the pulse laser beam is A, and the other opening diameter (a lower opening diameter in Fig. 5) is B, the microhole satisfies the relationship of A ≥ B, and the wall surface of the through-hole has none of fissures, irregularities and cracks having a depth of 0.3 x A or greater. No fusion of the resin is also observed. The average hole diameter of the through-hole is about 86 µm.

### Comparative Example 2

Abrasion working was conducted in the same manner as in Example 2 except that a quartz substrate provided with no bore was used as a support. As illustrated in Fig. 6 (SEM photograph), an opening portion of the through-hole on the side (upper side) coming into contact with the support for the stretched porous PTFE film is greatly deformed under an influence considered as an influence of particles flown off by abrasion of the support. The wall surface of the through-hole is also found to be in an uneven state.

More specifically, acute irregularities and cracks, and fused marks of the resin are observed on the support side of the stretched porous PTFE film. It may be inferred that this is attributed to the fact that the matter flown off by the abrasion of the support after the pulse laser beam passes through the material to be wrought collides with the pulse laser beam to incur scattering of the laser beam, thereby adversely affecting the section of the through-hole. Burr-like protuberance is observed at the opening edge of the through-hole. The form of the through-hole is not a circle, but an indented indeterminate form.

### INDUSTRIAL APPLICABILITY

According to the present invention, there can be provided stretched porous PTFE materials in which a microhole is formed, and a microporous structure of a wall surface in the microhole is substantially retained without being destroyed. According to the production process of the present invention, a microhole having desired form and size can also be formed in a stretched porous PTFE material by precise working substantially without destroying the microporous structure thereof. Further, according to the abrasion working process of the present invention, no particle flown off by abrasion of a support is generated, and materials to be wrought having a wrought portion excellent in form can be produced.

The microhole-formed stretched porous PTFE materials according to the present invention are suitable for use as substrate materials that are excellent in heat resistance, chemical resistance, mechanical properties and dielectric characteristics and have an even pore diameter distribution, moderate elasticity and elastic recovery property, or the like. More specifically, the materials can be suitably applied as substrate materials to, for example, technical fields of mounting members of semiconductor devices, members for inspection of electrical reliability, and the like. According to the abrasion working process of the present invention, there can be provided various kinds of products precisely and beautifully abraded.

## Claims

1. A microhole-formed stretched porous polytetrafluoroethylene material, **characterized in that** a microhole having a hole diameter greater than an average pore diameter of a stretched porous polytetrafluoroethylene material having a microporous structure comprising fibrils and nodes connected to each other by the fibrils is formed in the stretched porous polytetrafluoroethylene material by irradiation of a pulse laser beam having a pulse length of at most 10 picoseconds, and the microporous structure of the wall surface of the microhole is substantially retained without being destroyed.

2. The microhole-formed stretched porous polytetrafluoroethylene material according to claim 1, wherein the hole diameter of the microhole is from 0.1 µm to 1,000 µm.

3. The microhole-formed stretched porous polytetrafluoroethylene material according to claim 1, wherein the stretched porous PTFE material has a porosity of at least 20% and an average pore diameter of at most 10 µm.

4. The microhole-formed stretched porous polytetrafluoroethylene material according to claim 1, wherein the stretched porous polytetrafluoroethylene material is a stretched porous polytetrafluoroethylene sheet or film having a thickness of from 5 µm to 3 mm.

5. The microhole-formed stretched porous polytetrafluoroethylene material according to claim 1, wherein the wall surface of the microhole shows a smooth form having none of fissures, irregularities and cracks having a depth of at least 0.5 x A, wherein A is a diameter of an opening portion formed by the irradiation of the pulse laser beam.

6. The microhole-formed stretched porous polytetrafluoroethylene material according to claim 1, wherein an opening portion of the through-hole draws an even contour line of a prescribed form, and no burr-like protuberance having a height of at least 30 µm is present at an opening edge of the through-hole.

7. The microhole-formed stretched porous polytetrafluoroethylene material according to claim 1, wherein the microhole is formed by irradiating the stretched porous polytetrafluoroethylene material with the pulse laser beam in a state that the stretched porous polytetrafluoroethylene material has been supported on a support, and at this time, using, as the support, a support provided with a site coming into no contact with the stretched porous polytetrafluoroethylene material at a region corresponding to a target region of the stretched porous polytetrafluoroethylene material, in which the microhole is formed.

8. A process for producing a microhole-formed stretched porous polytetrafluoroethylene material, which comprises irradiating a stretched porous polytetrafluoroethylene material having a microporous structure comprising fibrils and nodes connected to each other by the fibrils with a pulse laser beam having a pulse length of at most 10 picoseconds to form a microhole having a hole diameter greater than an average pore diameter of the stretched porous polytetrafluoroethylene material, wherein the microporous structure of the wall surface of the microhole is substantially retained without being destroyed.

9. The production process according to claim 8, wherein the stretched porous polytetrafluoroethylene material is irradiated with the pulse laser beam in a state that the stretched porous polytetrafluoroethylene material has been supported on a support, and at this time, a support provided with a site coming into no contact with the stretched porous polytetrafluoroethylene material at a region corresponding to a target region of the stretched porous polytetrafluoroethylene material, in which the microhole is formed, is used as the support.

10. The production process according to claim 9, wherein the support provided with the site coming into no contact with the stretched porous polytetrafluoroethylene material is a support provided with a bore as the site at the region corresponding to the target region of the stretched porous polytetrafluoroethylene material, in which the microhole is formed.

11. The production process according to claim 8, wherein the pulse length of the pulse laser beam irradiated is from 10 femtoseconds to 10 picoseconds.

12. The production process according to claim 8, wherein the fluence of the pulse laser beam irradiated is at least 0.1 J/cm².

13. The production process according to claim 8, wherein the fluence of the pulse laser beam irradiated is 0.1 to 20 J/cm².

14. The production process according to claim 8, wherein the wavelength of the pulse laser beam irradiated is from 200 nm to 1 µm.

15. The production process according to claim 8, wherein the hole diameter of the microhole is from 0.1 µm to 1,000 µm.

16. The production process according to claim 8, wherein the stretched porous polytetrafluoroethylene material has a porosity of at least 20% and an average pore diameter of at most 10 µm.

17. The production process according to claim 8, wherein the stretched porous polytetrafluoroethylene material is a stretched porous polytetrafluoroethylene sheet or film having a thickness of from 5 µm to 3 mm.

18. A process for abrading a material to be wrought by irradiation of a pulse laser beam, which comprises irradiating the material to be wrought with the pulse laser beam in a state that the material to be wrought has been supported on a support, and at this time, using, as the support, a support provided with a site coming into no contact with the material to be wrought at a region corresponding to a target working region of the material to be wrought.

19. The abrading process according to claim 18, wherein the support provided with the site coming into no contact with the material to be wrought is a support provided with a bore as the site at the region corresponding to the target working region of the material to be wrought.

20. The abrading process according to claim 18, wherein the pulse length of the pulse laser beam irradiated is from 10 femtoseconds to 10 picoseconds.

21. The abrading process according to claim 18, wherein the fluence of the pulse laser beam irradiated is at least 0.1 J/cm².

22. The abrading process according to claim 18, wherein the fluence of the pulse laser beam irradiated is at most 20 J/cm².

23. The abrading process according to claim 18, wherein the wavelength of the pulse laser beam irradiated is from 200 nm to 1 µm.

24. The abrading process according to claim 18, wherein the material to be wrought is an organic polymeric material.

25. The abrading process according to claim 24, wherein the organic polymeric material is a fluorocarbon resin material.

26. The abrading process according to claim 25, wherein the organic polymeric material is a porous fluorocarbon resin material.

27. The abrading process according to claim 26, wherein the porous fluorocarbon resin material is a stretched porous polytetrafluoroethylene material.
